Europäisches Patentamt

European Patent Office

Office européen des brevets

(19)

(11) Veröffentlichungsnummer : **0 451 701 B1**

(12) **EUROPÄISCHE PATENTSCHRIFT**

(45) Veröffentlichungstag der Patentschrift :
**04.05.94 Patentblatt 94/18**

(51) Int. Cl.$^5$ : **G01R 27/22**

(21) Anmeldenummer : **91105334.6**

(22) Anmeldetag : **04.04.91**

(54) **Verfahren zur kontaktlosen Messung des elektrischen Widerstands eines Untersuchungsmaterials.**

(30) Priorität : **11.04.90 DE 4011637**
**16.07.90 DE 4022563**

(43) Veröffentlichungstag der Anmeldung :
**16.10.91 Patentblatt 91/42**

(45) Bekanntmachung des Hinweises auf die
Patenterteilung :
**04.05.94 Patentblatt 94/18**

(84) Benannte Vertragsstaaten :
**AT BE CH DE DK ES FR GB GR IT LI LU NL SE**

(56) Entgegenhaltungen :
**EP-A- 0 192 416**
**EP-A- 0 324 193**
**DE-A- 2 239 359**
**DE-A- 3 815 011**
**US-A- 3 408 566**
**US-A- 3 967 191**
**US-A- 4 554 493**

(73) Patentinhaber : **FLACHGLAS**
**AKTIENGESELLSCHAFT**
**Auf der Reihe 2**
**D-45884 Gelsenkirchen (DE)**

(72) Erfinder : **Pingel, Ulrich, Dipl.-Ing.**
**Venusweg 13**
**W-4730 Marl (DE)**
Erfinder : **Nolte, Hans-H., Dipl.-Phys.**
**Beethovenstrasse 29**
**W-4650 Gelsenkirchen (DE)**

(74) Vertreter : **Gesthuysen, Hans Dieter, Dipl.-Ing.**
**et al**
**Patentanwälte Gesthuysen + von Rohr**
**Postfach 10 13 33**
**D-45013 Essen (DE)**

## Beschreibung

Die Erfindung betrifft ein Verfahren zur kontaktlosen Messung des elektrischen Widerstands (bzw. der elektrischen Leitfähigkeit) eines vorzugsweise flächenhaft vorliegenden Materials (= Untersuchungsmaterial), wobei in das Untersuchungsmaterial mit Hilfe von zwei Koppelelektroden ein Wechselstrom kapazitiv eingekoppelt wird sowie eine Steuereinrichtung zur Steuerung des Scheibenwischers oder der Scheibenwischer der Windschutzscheibe eines Kraftfahrzeugs, mit einem aus mindestens zwei Koppelelektroden bestehenden Sensor, mindestens zwei, mit den Koppelelektroden verbundenen Kontaktelementen und einer an die Kontaktelemente angeschlossenen Auswerteschaltung.

Verfahren der zuvor angesprochenen Art sind vielfach bekannt (vgl. die DE-OSen 2 239 359 und 38 15 011, die EP-OSen 1192 416 und 0 324 193 sowie die US-PSen 3,408,566, 3,967,191 und 4,554,439). Eine Steuereinrichtung zur Steuerung des Scheibenwischers oder der Scheibenwischer der Windschutzscheibe eines Kraftfrahrzeugs der eingangs genannten Art ist aus der US-PS 4,554,493 bekannt. Allen bekannten Verfahren der in Rede stehenden Art und auch der bekannten Steuereinrichtung ist gemeinsam, daß die Messung des elektrischen Widerstands (bzw. der elektrischen Leitfähigkeit) nicht hinreichend genau ist.

Folglich liegt der Erfindung die Aufgabe zugrunde, das eingangs grundsätzlich beschriebene Verfahren sowie die bekannte Steuereinrichtung so auszugestalten und weiterzubilden, daß damit der elektrsiche Widerstand (bzw. die elektrische Leitfähigkeit) eines Untersuchungsmaterials relativ einfach mit verbesserter Genauigkeit gemessen werden kann; insbesondere sollen Meßfehler, die im Stand der Technik beispielsweise durch Änderungen des Abstands zwischen dem Untersuchungsmaterial und den Koppelelektroden auftreten, reduziert werden.

Das erfindungsgemäße Verfahren, bei dem die zuvor aufgezeigte Aufgabe gelöst ist, ist nun dadurch gekennzeichnet, daß die Gesamtimpedanz bei mindestens drei unterschiedlichen Frequenzen gemessen und daraus die Streukapazität zwischen den beiden Koppelelektroden, die Koppelkapazität zwischen den beiden Koppelelektroden und dem Untersuchungsmaterial sowie der Widerstand des Untersuchungsmaterials bestimmt wird. Dementsprechend ist die zuvor aufgezeigte Aufgabe bei der erfindungsgemäßen Steuereinrichtung dadurch gelöst, daß die Auswerteschaltung auf einer Erfassung der Gesamtimpedanz zwischen den zwei oder mehreren Koppelelektroden bei mindestens drei unterschiedlichen Frequenzen basiert.

Der Erfindung liegt zunächst die bekannte Tatsache zugrunde, daß sich dann, wenn zwei elektrische leitende Flächen, hier Koppelelektroden genannt, in die Nähe eines leitfähigen Mediums, hier Untersuchungsmaterial genannt, gebracht werden, zwischen den Koppelelektroden und dem Untersuchungsmaterial eine Kapazität ausbildet, hier Koppelkapazität genannt. Der Erfindung liegt ferner die bisher meßtechnisch unberücksichtigt gebliebene Tatsache zugrunde, daß sich auch zwischen den beiden Koppelelektroden eine Kapazität ausbildet, hier Streukapazität genannt. Für den durch eine an die Koppelelektroden angelegte Wechselspannung fließenden Wechselstrom ist also eine Gesamtimpedanz wirksam, die aus der Streukapazität, der Koppelkapazität und dem zu messenden Widerstand besteht. Dabei liegt die Streukapazität parallel zu der Reihenschaltung aus der Koppelkapazität und dem zu messenden Widerstand.

Eine bevorzugte Ausführungsform des erfindungsgemäßen Verfahrens, der besondere Bedeutung zukommt, ist dadurch gekennzeichnet, daß mit einem Wechselstrom hoher Frequenz die Gesamtimpedanz gemessen und daraus die Streukapazität zwischen den beiden Koppelelektroden bestimmt wird, daß mit einem Wechselstrom niedriger Frequenz die Gesamtimpedanz gemessen und daraus unter Berücksichtigung der Streukapazität die Koppelkapazität zwischen den beiden Koppelelektroden und dem Untersuchungsmaterial bestimmt wird und daß mit einem Wechselstrom einer zwischen der hohen und der niedrigen Frequenz liegenden Frequenz die Gesamtimpedanz gemessen und daraus unter Berücksichtigung der Streukapazität und der Koppelkapazität der Widerstand des Untersuchungsmaterials bestimmt wird. Dabei nutzt die Erfindung die Tatsache, daß die Koppelelektroden so dimensioniert und die Abstände so realisiert werden können, daß die Streukapazität klein ist gegenüber der Koppelkapazität. Dann gilt nämlich,

daß bei relativ hoher Frequenz die Gesamtimpedanz im wesentlichen durch die bei hoher Frequenz niederohmige Streukapazität bestimmt ist; zwischen der angelegten Wechselspannung und dem fließenden Wechselstrom beträgt die Phasenverschiebung nahezu 90°,

daß bei relativ niedriger Frequenz die Gesamtimpedanz im wesentlichen durch die bei niedriger Frequenz hochohmige Koppelkapazität bestimmt ist; zwischen der angelegten Wechselspannung und dem fließenden Wechselstrom beträgt auch in diesem Fall die Phasenverschiebung nahezu 90°.

Zwischen der hohen Frequenz und der niedrigen Frequenz existiert eine Frequenz, bei der die Phasenverschiebung zwischen der angelegten Wechselspannung und dem fließenden Wechselstrom ein Minimun hat. Vorzugsweise wird deshalb der Realteil der Gesamtimpedanz mit einem Wechselstrom der Frequenz gemessen, bei dem ein Phasenverschiebungsminimum auftritt (Phasenverschiebung zwischen angelegter Wechselspannung und eingekoppeltem Wechselstrom).

Aus den erfindungsgemäß vorzunehmenden drei Messungen - Messung der Gesamtimpedanz mit einem Wechselstrom hoher Frequenz, Messung der Gesamtimpedanz mit einem Wechselstrom niedriger Frequenz und Messung der Gesamtimpedanz mit einem Wechselstrom einer zwischen der hohen und der niedrigen Frequenz liegenden Frequenz - lassen sich dann die Streukapazität, die Koppelkapazität und der zu messende Widerstand bestimmen, - und zwar mit Hilfe der folgenden Gleichungen:

$$Z = \frac{\omega^2 RC_K^2 - j\omega(C_S + C_K + \omega^2 R^2 C_S C_K^2)}{(\omega^2 R C_S C_K)^2 + \omega^2 (C_S + C_K)^2} \quad (1)$$

$$X_I = - \frac{C_S + C_K + \omega^2 R^2 C_S C_K^2}{\omega^3 R^2 C_S^2 C_K^2 + \omega(C_S + C_K)^2} \quad (2)$$

$$X_R = \frac{RC_K^2}{(\omega R C_S K_K)^2 + (C_S + C_K)^2} \quad (3)$$

$$C_S \approx - (\omega_1 X_I)^{-1} \quad (4)$$

$$C_K \approx - \frac{1}{\omega_3 X_I} - C_S \quad (5)$$

$$R \sim \frac{1}{2\omega_2^2 X_R C_S} \left| 1 - \sqrt{1 - \left( \frac{2\omega_2 X_R C_S (C_S + C_K)}{C_K} \right)^2} \right| \quad (6)$$

mit

$Z$ = Gesamtimpedanz,

$X_I$ = Imaginärteil der Gesamtimpedanz,

$X_R$ = Realteil der Gesamtimpedanz,

$C_S$ = Streukapazität,

$C_K$ = Koppelkapazität,

$R$ = Widerstand.

Dabei resultieren die Gleichungen (1), (2) und (3) aus der exakten Umsetzung des Ersatzschaltbildes, das dem erfindungsgemäßen Verfahren zugrundeliegt. Die Gleichungen (4), (5) und (6) beruhen auf Näherungen mit den Frequenzen $\omega_1 \gg \omega_2 \gg \omega_3$, wobei $\omega_2$ im Bereich des Phasenverschiebungsminimums liegt.

Wird das erfindungsgemäße Verfahren z. B. mit festinstallierten Koppelelektroden durchgeführt, so kann man die Streukapazität und/oder die Koppelkapazität aus einer einmaligen Messung gewinnen, so daß dann zur Ermittlung des Widerstands des Untersuchungsmaterials nur noch laufende Messungen bei zwei Frequenzen oder bei einer Frequenz erforderlich sind.

Im einzelnen gibt es nun verschiedene Möglichkeiten, das erfindungsgemäße Verfahren auszugestalten und weiterzubilden. Dazu wird verwiesen einerseits auf die dem Patentanspruch 1 nachgeordneten Patentansprüche, andererseits auf ein bevorzugtes Ausführungsbeispiel, das im folgenden in Verbindung mit der Zeichnung erläutert wird. In der Zeichnung zeigt

Fig. 1        einen Querschnitt durch eine bevorzugte Ausführungsform einer Anordnung zur Durchführung des erfindungsgemäßen Verfahrens,

Fig. 2        eine Draufsicht auf die Anordnung nach Fig. 1,

Fig. 3        das Ersatzschaltbild für die Anordnung nach den Fig. 1 und 2, ergänzt um einen Meßwiderstand,

Fig. 4        das Blockschaltbild einer möglichen Auswerteschaltung für das erfindungsgemäße Verfahren,

Fig. 5        eine graphische Darstellung des Betrages der Gesamtimpedanz und der Phasenverschiebung in Abhängigkeit von der Frequenz,

Fig. 6        eine graphische Darstellung des Betrages der Gesamtimpedanz, des Imaginärteils der Gesamtimpedanz, des Realteils der Gesamtimpedanz und der Phasenverschiebung in Abhängigkeit von der Frequenz,

Fig. 7        eine graphische Darstellung des auftretenden Meßfehlers ohne Berücksichtigung der Streukapazität,

Fig. 8        schematisch, eine Windschutzscheibe eines Kraftfahrzeugs mit einer auf dem erfindungsgemäßen Verfahren beruhenden Steuereinrichtung zur Steuerung des Scheibenwischers bzw. der Scheibenwischer,

Fig. 9 in gegenüber der Fig. 8 vergrößerter Darstellung, teilweise perspektivisch, die Steuereinrichtung nach Fig. 8,

Fig. 10 in gegenüber der Fig. 8 vergrößerter Darstellung, einen Schnitt durch den Gegenstand nach Fig. 8, längs der Linie X-X, und

Fig. 11 das Ersatzschaltbild für die Steuereinrichtung nach den Fig. 8 bis 10.

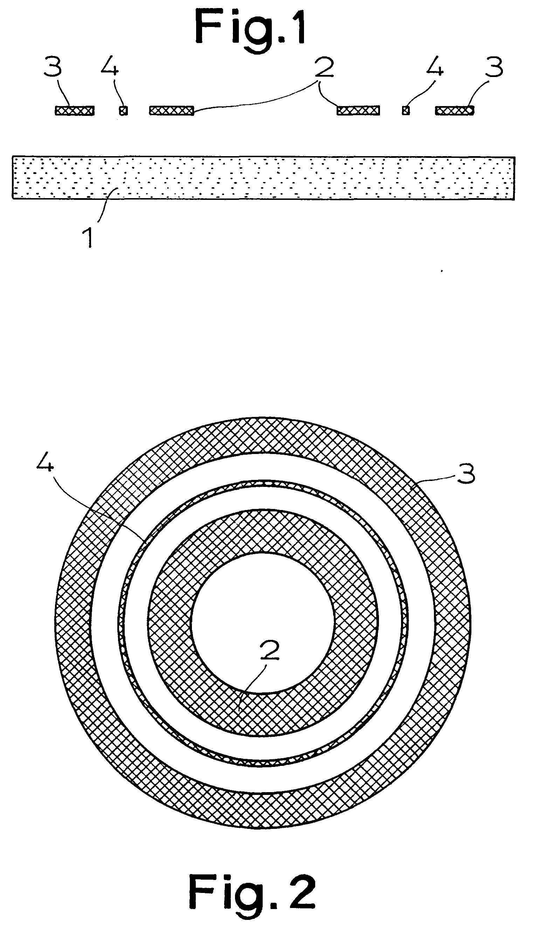

Die Fig. 1 und 2 zeigen den mechanischen Aufbau einer bevorzugten Ausführungsform einer Anordnung zur Durchführung des erfindungsgemäßen Verfahrens, also eines Verfahrens zur kontaktlosen Messung des elektrischen Widerstandes (bzw. der elektrischen Leitfähigkeit) eines Untersuchungsmaterials 1, wobei in das Untersuchungsmaterial 1 mit Hilfe von zwei Koppelelektroden 2, 3 ein Wechselstrom kapazitiv eingekoppelt wird. Die Fig. 1 und 2 zeigen insoweit eine bevorzugte Ausführungsform einer Anordnung zur Durchführung des erfindungsgemäßen Verfahrens, als die Koppelelektroden 2, 3 flächengleich ausgeführt sind und zusätzlich zu den beiden Koppelelektroden 2, 3 noch eine Auskoppelelektrode 4 vorgesehen ist.

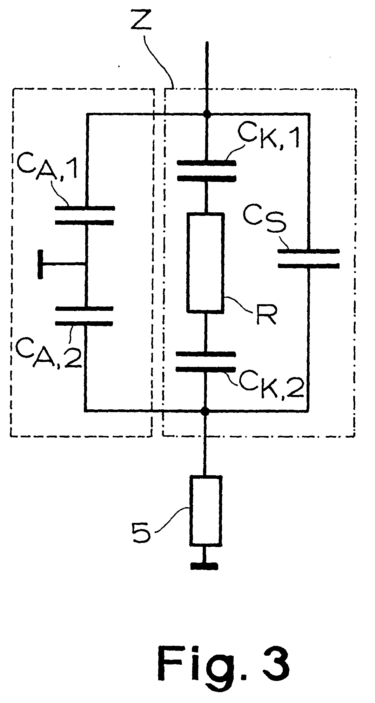

Die Fig. 3 zeigt nun das Ersatzschaltbild, das dem erfindungsgemäßen Verfahren zugrundeliegt. Zu diesem Ersatzschaltbild gehört zunächst der Widerstand R; es handelt sich hier um den elektrischen Widerstand des Untersuchungsmaterials 1, der mit Hilfe des erfindungsgemäßen Verfahrens kontaktlos gemessen werden soll. Zu der in Fig. 3 dargestellten Schaltung gehören weiter zwei Teil-Koppelkapazitäten $C_{K,1}$ und $C_{K,2}$; es handelt sich um die Kapazitäten zwischen der Koppelelektrode 2 und dem Untersuchungsmaterial 1 bzw. zwischen der Koppelelektrode 3 und dem Untersuchungsmaterial 1. Die beiden Teil-Koppelkapazitäten $C_{K,1}$ und $C_{K,2}$ bilden zusammen die Koppelkapazität $C_K$. Zu der in Fig. 3 dargestellten Schaltung gehört ferner eine Streukapazität $C_S$; es handelt sich um die Kapazität zwischen den beiden Koppelelektroden 2 und 3.

Zuvor ist bereits ausgeführt worden, daß im dargestellten Ausführungsbeispiel zwischen den beiden Koppelelektroden 2 und 3 noch eine Auskoppelelektrode 4 vorgesehen ist. Die Auskoppelelektrode 4 dient zur Reduzierung des Einflusses der Streukapazität $C_S$ und liegt auf Grundpotential; mit Hilfe der Auskoppelelektrode 4 wird ein Teil des über die Streukapazität $C_S$ fliessenden Stromes ausgekoppelt. In der elektrischen Schaltung, die Fig. 3 zeigt, ist die Auskoppelelektrode 4 durch zwei Teil-Auskoppelkapazitäten $C_{A,1}$ und $C_{A,2}$ berücksichtigt.

In der in Fig. 3 dargestellten Schaltung bilden der Widerstand R, die beiden Teil-Koppelkapazitäten $C_{K,1}$ und $C_{K,2}$ bzw. die Koppelkapazität $C_K$ und die Streukapazität $C_S$ die Gesamtimpedanz Z. Zusätzlich ist noch ein Meßwiderstand 5 vorgesehen.

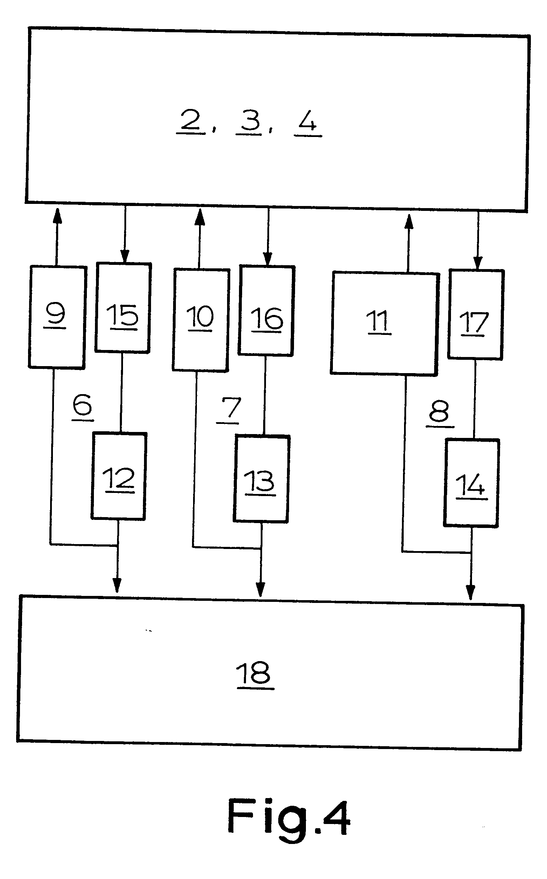

Eine für das erfindungsgemäße Verfahren denkbare Auswerteschaltung zeigt Fig. 4, und zwar in Form eines Blockschaltbildes. Im oberen Teil des in Fig. 4 dargestellten Blockschaltbildes sind zusammengefaßt die beiden Koppelelektroden 2 und 3 sowie die Auskoppelelektrode 4 vorgesehen. Im übrigen enthält die Auswerteschaltung einen Versorgungsteil 6 für die Wechselspannung hoher Frequenz, einen Versorgungsteil 7 für die Wechselspannung niedriger Frequenz und einen Versorgungsteil 8 für die Wechselspannung mit einer zwischen der hohen und der niedrigen Frequenz liegenden, veränderbaren Frequenz. Zu jedem Versorgungsteil 6, 7, 8 gehört ein Oszillator 9, 10, 11, ein Regler 12, 13, 14 und ein Filter 15, 16, 17. Schließlich ist noch ein Rechner 18 vorgesehen, der die Auswertung im einzelnen vornimmt.

Erfindungsgemäß wird nun so vorgegangen, daß in einem ersten Schritt mit einem Wechselstrom hoher Frequenz der Imaginärteil $X_I$ der Gesamtimpedanz Z gemessen und daraus die Streukapazität $C_S$ zwischen den beiden Koppelelektroden 2 und 3 bestimmt wird, und zwar mit Hilfe der Gleichung (4), daß dann in einem zweiten Schritt mit einem Wechselstrom niedriger Frequenz der Imaginärteil $X_I$ der Gesamtimpedanz gemessen und daraus unter Berücksichtigung der Streukapazität $C_S$ die Koppelkapazität $C_K$ zwischen den beiden Koppelelektroden 2 bzw. 3 und dem Untersuchungsmaterial 1 bestimmt wird, und zwar mit Hilfe der Gleichung (5), und daß schließlich in einem dritten Schritt mit einem Wechselstrom einer zwischen der hohen und der niedrigen Frequenz liegenden Frequenz, nämlich mit einem Wechselstrom der Frequenz, bei dem ein Phasenverschiebungsminimum auftritt, der Realteil $X_R$ der Gesamtimpedanz gemessen und daraus unter Berücksichtigung der Streukapazität $C_S$ und der Koppelkapazität $C_K$ der Widerstand R des Untersuchungsmaterials 1 bestimmt wird, und zwar mit Hilfe der Gleichung (6).

In den Figuren ist nicht dargestellt, daß zur weiteren Erhöhung der Meßgenauigkeit mit zwei identischen Elektrodenanordnungen in definiertem, unterschiedlichen Abstand zum Untersuchungsmaterial 1 gemessen werden kann.

Abhängig von der Gestaltung der Koppelelektroden und/oder vom Abstand zwischen den Koppelelektroden und dem Untersuchungsmaterial kann eine Einschnürung der elektrischen Feldlinien auftreten, was in einer Änderung der effektiven Fläche der Koppelelektroden und damit in einer zusätzlichen Änderung des gemessenen Widerstandes resultiert. Eine Kalibrierung dieses Effektes - Erstellung einer Eichkurve für den Widerstand R als Funktion des Verhältnisses von Streukapazität $C_S$ zu Koppelkapazität $C_K$ - sowie eine effektive Korrektur läßt sich durch die Auswertung der gemessenen Werte der Streukapazität und der Koppelkapazität erreichen.

Im übrigen kann die Abhängigkeit der Kapazitätswerte vom Abstand der Koppelelektroden zur Abstandsregelung eingesetzt werden, wobei eine kontaktlose Messung mit geringem Abstand (= hohe Meßgenauigkeit) ohne Kollisionsgefahr möglich ist. Ein weiterer Vorteil ist der Wegfall der sonst notwendigen Abstandssensoren.

Weiter oben ist ausgeführt worden, daß bei dem in Fig. 3 dargestellten Ersatzschaltbild noch ein Meßwiderstand 5 vorgesehen ist. Die Wechselspannung wird an die Reihenschaltung aus der Elektrodenanordnung dem Meßwiderstand 5 angelegt. Als Maß für den fließenden Wechselstrom wird der Spannungsabfall am Meßwiderstand 5 herangezogen. Dabei wird der Meßwiderstand 5 so dimensioniert, daß der Spannungsabfall am Meßwiderstand 5 klein ist gegenüber der insgesamt angelegten Wechselspannung.

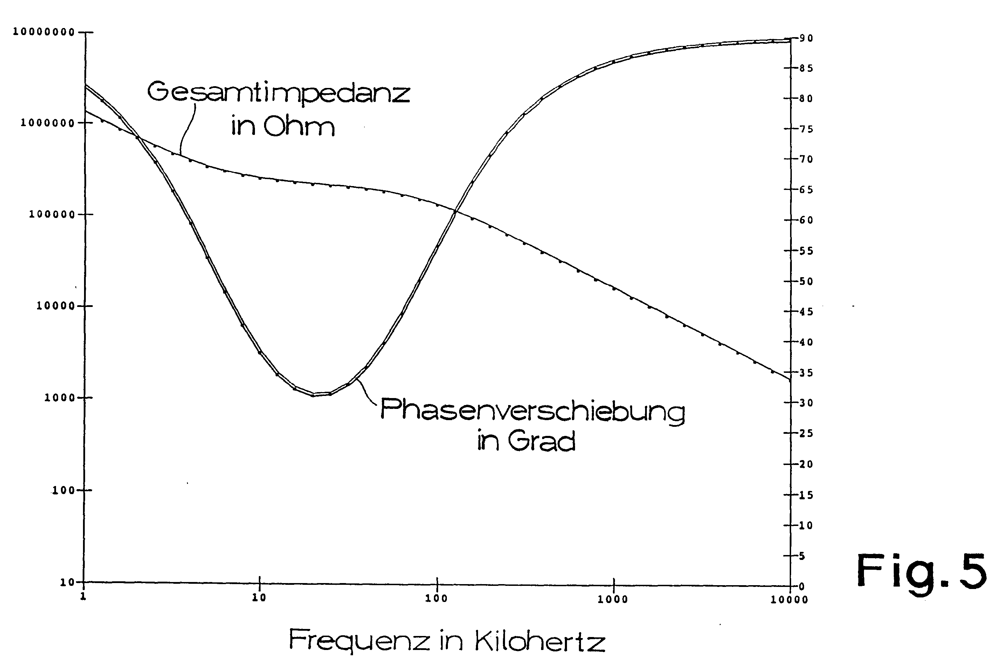

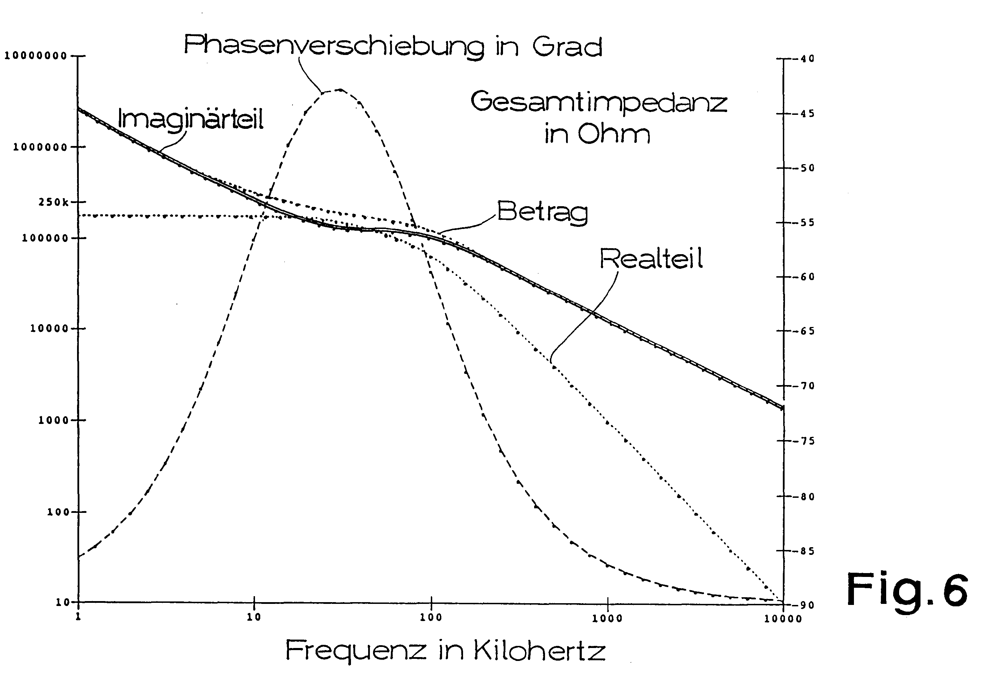

Die Fig. 5 und 6 zeigen sehr deutlich, daß bei relativ hoher Frequenz der angelegten Wechselspannung die Phasenverschiebung zwischen der angelegten Wechselspannung und dem fließenden Wechselstrom nahezu 90° beträgt und daß bei relativ niedriger Frequenz der angelegten Wechselspannung die Phasenverschiebung zwischen der angelegten Wechselspannung und dem fließenden Wechselstrom ebenfalls nahezu 90° beträgt. Sehr deutlich zeigen die Fig. 5 und 6 auch, daß zwischen der hohen Frequenz und der niedrigen Frequenz eine Frequenz existiert, bei der die Phasenverschiebung zwischen der angelegten Wechselspannung und dem fließenden Strom ein Minimum hat.

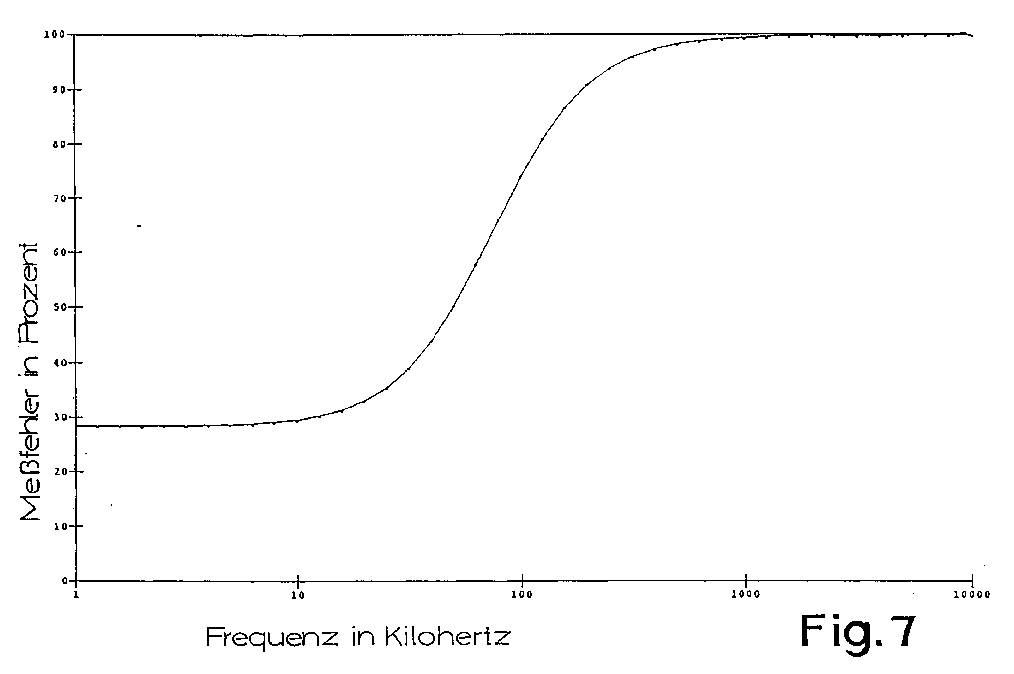

Aus der Fig. 7 ist zu erkennen, daß dann, wenn die Streukapazität $C_S$ nicht berücksichtigt wird, der auftretende Meßfehler erheblich ist. Dieser Meßfehler beträgt bei niedriger Frequenz fast 30 % und bei der Frequenz, bei der ein Phasenverschiebungsminimum auftritt, fast 40 %; oberhalb der Frequenz, bei der ein Phasenverschiebungsminimum auftritt wächst der relative Meßfehler sehr schnell auf 100 %.

Im übrigen zeigen die Fig. 5 bis 7 die Verhältnisse für den Fall, daß die Streukapazität $C_S$ 10 pF, die Koppelkapazität $C_K$ 55pF und der Widerstand R 250 k$\Omega$ beträgt.

Das erfindungsgemäße Verfahren kann zur kontaktlosen Messung des elektrischen Widerstands (bzw. der elektrischen Leitfähigkeit) verschiedenster Materialien angewendet werden, z. B. zur kontaktlosen Messung des elektrischen Widerstandes (bzw. der elektrischen Leitfähigkeit) von Kunststofffolien, Papierbahnen usw.; es eignet sich zur Bestimmung von Widerständen im Bereich von etwa 10 bis $10^6$ $\Omega/cm^2$.

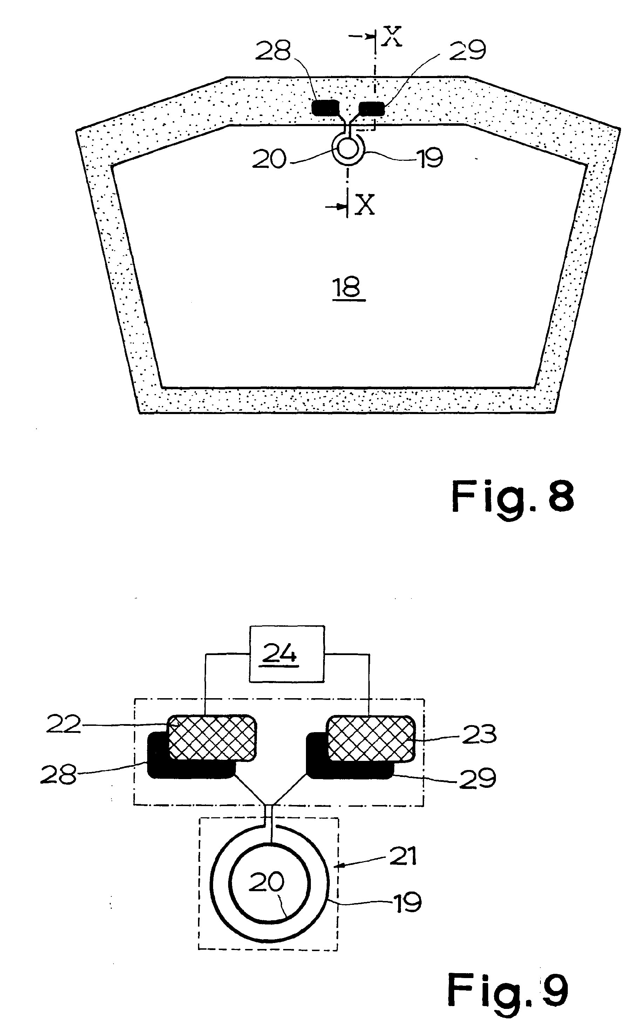

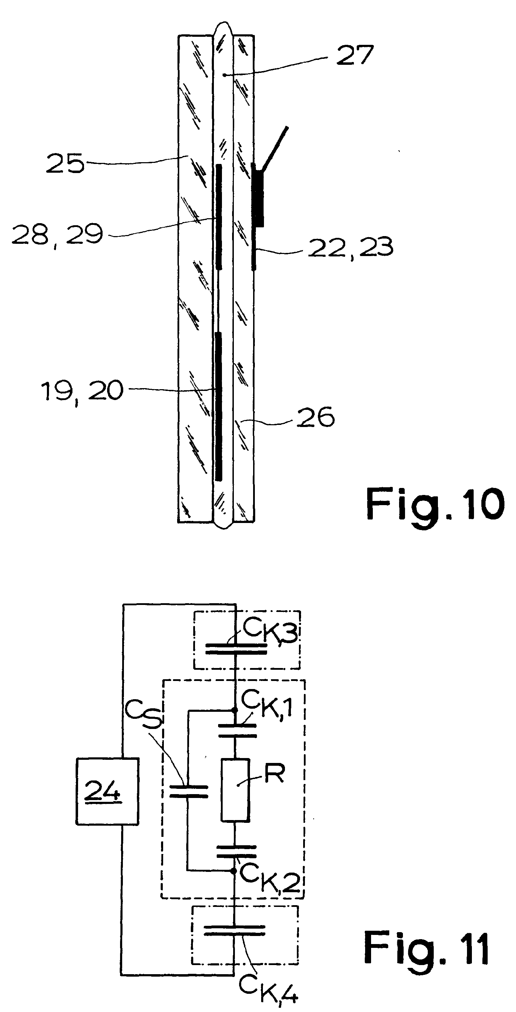

Das erfindungsgemäße Verfahren läßt sich besonders gut auch zur Steuerung des Scheibenwischers oder der Scheibenwischer der - in den Fig. 8 und 10 angedeuteten - Windschutzscheibe 18 eines Kraftfahrzeugs anwenden. Folglich ist Gegenstand der Erfindung auch eine Steuereinrichtung zur Steuerung des Scheibenwischers oder der Scheibenwischer der Windschutzscheibe 18 eines Kraftfahrzeuges. Zu einer solchen Steuereinrichtung gehören, wie dies die Fig. 8 bis 11 insgesamt zeigen, ein mindestens aus zwei Koppelelektroden 19, 20 bestehender Sensor 21, mindestens zwei Kontaktelemente 22, 23 und eine an die Kontaktelemente 22, 23 angeschlossene Auswerteschaltung 24.

Grundsätzlich könnten die Koppelelektroden galvanisch mit den Kontaktelementen verbunden sein. In aller Regel ist die Windschutzscheibe 18 eines Kraftfahrzeugs als Verbundscheibe mit einer äußeren Glasscheibe 25, einer inneren Glasscheibe 26 und einer zwischen der äußeren Glasscheibe 25 und der inneren Glasscheibe 26 vorgesehenen Sicherheitsfolie 27 ausgeführt. Dann empfiehlt sich die in den Fig. 8 bis 11 insgesamt dargestellte Ausführungsform einer Steuereinrichtung zur Steuerung des Scheibenwischers oder der Scheibenwischer der Windschutzscheibe 18 eines Kraftfahrzeugs, die dadurch gekennzeichnet ist, daß die Koppelelektroden 19, 20 zwischen der äußeren Glasscheibe 25 und der Sicherheitsfolie 27 vorgesehen sind, zwischen der äußeren Glasscheibe 25 und der Sicherheitsfolie 27 zwei Kontaktelektroden 28, 29 vorgesehen sind, die Koppelelektroden 19, 20 galvanisch mit den Kontaktelektroden 28, 29 verbunden sind und die Kontaktelemente 22, 23, den Kontaktelektroden 28, 29 zugeordnet, auf der der Sicherheitsfolie 27 abgewandten Seite der inneren Glasscheibe 26 vorgesehen sind. Hier ist also zwischen den Kontaktelektroden 28, 29 und den Kontaktelementen 22, 23 eine kapazitive Kopplungs realisiert. Statt einer solchen kapazitiven Kopplung könnte auch eine induktive Kopplung realisiert werden. Grundsätzlich besteht auch dann, wenn die Windschutzscheibe als Verbundscheibe ausgeführt ist, die Möglichkeit, die Koppelelektroden galvanisch mit den Kontaktelementen zu verbinden.

Die erfindungsgemäße Steuereinrichtung zur Steuerung des Scheibenwischers oder der Scheibenwischer der Windschutzscheibe eines Kraftfahrzeugs basiert auf der Erfassung der - komplexen - Gesamtimpedanz zwischen zwei oder mehreren Koppelelektroden bei mindestens drei unterschiedliche Frequenzen. Der kapazitiv eingekoppelte Wechselstrom wird beeinflußt durch Wasser auf der Windschutzscheibe. Einerseits wird durch die dielektrischen Eigenschaften des Wassers die meßbare Kapazität zwischen den Koppelektroden erhöht. Andererseits bildet sich zwischen einem Wasserfilm und den Koppelelektroden eine zusätzliche Kapazität aus, die einen Wechselstrom durch den Wasserfilm zur Folge hat. Bei der Bestimmung der - komplexen - Gesamtimpedanz wird der kapazitive Imaginärteil der Gesamtimpedanz und der Realteil der Gesamtimpedanz so ermittelt, wie das weiter oben bereits beschrieben worden ist.

Zur Klassifizierung von Wasser auf der Windschutzscheibe eines Kraftfahrzeugs kann man sich das Wasser vereinfacht durch eine Kombination von Extremfällen vorstellen, nämlich

a) gleichmäßig verteilter dicker Wasserfilm,

b) gleichmäßig verteilter dünner Wasserfilm,

c) große, nicht zusammenhängende, punktförmige Wassertropfen und

d) kleine, nicht zusammenhängende, punktförmige Wassertropfen.

Man beobachtet nun folgenden Zusammenhang zwischen dem kapazitiven Imaginärteil der Gesamtimpedanz und dem Realteil der Gesamtimpedanz in Abhängigkeit von dem sich auf der Windschutzscheibe befindenden Wasser:

a) Ein gleichmäßig verteilter Wasserfilm erzeugt einen niederohmigen Widerstand, der näherungsweise hyperbolisch von der Dicke des Wasserfilms abhängig ist. Punktförmige Wassertropfen stellen dagegen einen hochohmigen Widerstand dar.

b) Die Streukapazität der Koppelelektroden ändert sich hauptsächlich mit der Wassermenge im elektrischen Feld und ist im wesentlichen unabhängig davon, ob die Wassermenge in Form eines Wasserfilms oder in Form von nicht zusammenhängenden, punktförmigen Wassertropfen vorliegt.

c) Zwischen den Koppelelektroden und dem Wasser ist nur dann eine Koppelkapazität wirksam, wenn das Wasser als Wasserfilm vorliegt.

Zur Steuerung des Scheibenwischers ist es nun wünschenswert, neben einem Meßwert für die Wassermenge auch eine Information über die Verteilung des Wassers - Wasserfilm oder Wassertropfen - zu erhalten. Hierzu werden durch drei Messungen mit unterschiedlichen Frequenzen die Werte der Streukapazität, der Koppelkapazität und des Widerstandes ermittelt. Unter Ausnutzung der Kapazitätwerte und der Widerstandswerte sowie deren zeitlicher Änderung läßt sich dann eine Information über das auf der Windschutzscheibe vorhandene Wasser, Wassermenge und Wasserfilm oder punktförmige Wassertropfen, ableiten, die dann zur Steuerung des Scheibenwischers herangezogen wird.

Das in Fig. 11 dargestellte Ersatzschaltbild für die Steuereinrichtung nach den Fig. 8 bis 10 entspricht im wesentlichen dem in Fig. 3 dargestellten Ersatzschaltbild für die Anordnung nach den Fig. 1 und 2. Zusätzlich sind hier noch die Teil-Koppelkapazitäten $C_{K, 3}$ und $C_{K, 4}$ zwischen den Kontaktelementen 22, 23 und den Kontaktelektroden 28, 29 eingezeichnet.

Bei der Anwendung des erfindungsgemäßen Verfahrens auf die Steuerung des Scheibenwischers oder der Scheibenwischer der Windschutzscheibe eines Kraftfahrzeugs wird vorzugsweise die Gesamtimpedanz bei fünf unterschiedlichen Frequenzen gemessen, vorzugsweise zwischen 200 Hz und 5 MHz.

Da bei der Anwendung des erfindungsgemäßen Verfahrens auf die Steuerung des Scheibenwischers oder der Scheibenwischer der Windschutzscheibe eines Kraftfahrzeugs der Sensor 21 nicht immer gleichmäßig mit Wasser benetzt ist, tritt eine Verwischung der in den Figuren 5 bis 7 dargestellten Kurven auf. Deshalb werden die Meßwerte dahingehend ausgewertet,

daß einerseits der Imaginärteil der Gesamtimpedanz und der Realteil der Gesamtimpedanz an allen Meßpunkten errechnet werden,

daß andererseits die ermittelten Werte bzw. die ermittelten Kurven mit bekannten Werten bzw. mit bekannten Kurven verglichen werden.

Im übrigen empfiehlt es sich, vier Benetzungsarten zu unterscheiden, nämlich

a) trocken,

b) leicht besprüht,

c) Tropfen,

d) geschlossener Wasserfilm.

Dabei stellt man folgendes fest:

a) Trocken:

Konstante und geringe Kapazitätswerte, keine ohmschen Impedanzen im gesamten Frequenzbereich.

b) Leicht besprüht:

Hohe Kapazität im unteren Frequenzbereich, niedrige Kapazität im hohen Frequenzbereich, hohe ohmsche Impedanzen im mittleren Frequenzbereich, niedrige ohmsche Impedanzen im hohen Frequenzbereich.

c) Tropfen:

Mittlere Kapazität bei niedrigen und mittleren Frequenzen, Anstieg der ohmschen Impedanzen im hohen Frequenzbereich.

d) Geschlossener Wasserfilm:

Hohe Kapazität bei niedrigen und mittleren Frequenzen, Anstieg der ohmschen Impedanzen im hohen Frequenzbereich.

**Patentansprüche**

1. Verfahren zur kontaktlosen Messung des elektrischen Widerstandes (R) bzw. der elektrischen Leitfähigkeit eines vorzugsweise flächenhaft vorliegenden Untersuchungsmaterials (1), wobei in das Untersuchungsmaterial (1) mit Hilfe von zwei Koppelelektroden (2, 3) ein Wechselstrom kapazitiv eingekoppelt wird, **dadurch gekennzeichnet,** daß die Gesamtimpedanz (Z) bei mindestens drei unterschiedlichen Frequenzen gemessen und daraus die Streukapazität ($C_S$) zwischen den beiden Koppelelektroden (2, 3), die Koppelkapazität ($C_K$) zwischen den beiden Koppelelektroden (2, 3) und dem Untersuchungsmaterial (1) sowie der Widerstand (R) des Untersuchungsmaterials (1) bestimmt wird.

2. Verfahren nach Anspruch 1, dadurch gekennzeichnet, daß mit einem Wechselstrom hoher Frequenz die Gesamtimpedanz (Z) gemessen und daraus die Streukapazität ($C_S$) zwischen den beiden Koppelelektroden (2, 3) bestimmt wird, daß mit einem Wechselstrom niedriger Frequenz die Gesamtimpedanz (Z) gemessen und daraus unter Berücksichtigung der Streukapazität ($C_S$) die Koppelkapazität ($C_K$) zwischen den beiden Koppelelektroden (2, 3) und dem Untersuchungsmaterial (1) bestimmt wird und daß mit einem Wechselstrom einer zwischen der hohen und der niedrigen Frequenz liegenden Frequenz die Gesamtimpedanz (Z) gemessen und daraus unter Berücksichtigung der Streukapazität ($C_S$) und der Koppelkapazität ($C_K$) der Widerstand (R) des Untersuchungsmaterials (1) bestimmt wird.

3. Verfahren nach Anspruch 2, dadurch gekennzeichnet, daß der Realteil ($X_R$) der Gesamtimpedanz (Z) mit einem Wechselstrom der Frequenz gemessen wird, bei dem ein Phasenverschiebungsminimum auftritt.

4. Verfahren nach Anspruch 1, wobei die Koppelelektroden (2, 3) stationär angeordnet sind, dadurch gekennzeichnet, daß die Streukapazität ($C_S$) und/oder die Koppelkapazität ($C_K$) nur einmalig bestimmt wird.

5. Verfahren nach einem der Ansprüche 1 bis 4, dadurch gekennzeichnet, daß das kapazitive Einkoppeln des Wechselstroms in das Untersuchungsmaterial (1) mit Hilfe von zwei flächengleichen Koppelelektroden erfolgt.

6. Verfahren nach einem der Ansprüche 1 bis 5, dadurch gekennzeichnet, daß das kapazitive Einkoppeln des Wechselstroms in das Untersuchungsmaterial (1) mit Hilfe von zwei als konzentrische Ringe ausgeführten Koppelelektroden (2, 3) erfolgt.

7. Verfahren nach einem der Ansprüche 1 bis 6, dadurch gekennzeichnet, daß zur Reduzierung des Einflusses der Streukapazität ($C_S$) über eine zwischen den Koppelelektroden (2, 3) liegenden, z. B. auf Grundpotential liegende Auskoppelelektrode (4) ein Teil des über die Streukapazität ($C_S$) fließenden Stroms ausgekoppelt wird.

8. Verfahren nach einem der Ansprüche 1 bis 7, dadurch gekennzeichnet, daß zur Erhöhung der Meßgenauigkeit mit zwei identischen Elektrodenanordnungen in definiertem, unterschiedlichen Abstand zum Untersuchungsmaterial (1) gemessen wird.

9. Verfahren nach einem der Ansprüche 1 bis 8, dadurch gekennzeichnet, daß mit einer Elektrodenanordnung mit mehreren konzentrischen Ringen gemessen wird und die konzentrischen Ringe wahlweise als Koppelelektroden (2, 3) oder als auf Grundpotential liegendem Ring geschaltet oder nicht kontaktiert werden.

10. Verfahren nach einem der Ansprüche 1 bis 9, dadurch gekennzeichnet, daß mit einer Elektrodenanordnung gemessen wird, in der ein - kontaktierendes oder kontaktloses - Temperaturmeßgerät integriert ist und mit Hilfe der gemessenen Temperatur der Temperatureinfluß kompensiert wird.

11. Verfahren nach einem der Ansprüche 1 bis 10, dadurch gekennzeichnet, daß die gemessenen Werte der Streukapazität ($C_S$) und/oder der Koppelkapazität ($C_K$) zur Regelung des Abstandes zwischen der Elektrodenanordnung und dem Untersuchungsmaterial (1) verwendet werden.

12. Anwendung des Verfahrens nach einem der Ansprüche 1 bis 10 auf die Steuerung des Scheibenwischers oder der Scheibenwischer der Windschutzscheibe (18) eines Kraftfahrzeugs.

13. Anwendung des Verfahrens gemäß Anspruch 12, dadurch gekennzeichnet, daß die Gesamtimpedanz (Z) bei fünf unterschiedlichen Frequenzen gemessen wird, vorzugsweise zwischen 200 Hz und 5 MHz.

14. Steuereinrichtung zur Steuerung des Scheibenwischers oder der Scheibenwischer der Windschutzscheibe (18) eines Kraftfahrzeugs, mit einem aus mindestens zwei Koppelelektroden (19, 20) bestehenden Sensor (21), mindestens zwei, mit den Koppelelektroden (19, 20) verbundenen Kontaktelementen (22, 23) und einer an die Kontaktelemente (22, 23) angeschlossenen Auswerteschaltung (24), dadurch gekennzeichnet, daß die Auswerteschaltung (24) auf einer Erfassung der Gesamtimpedanz (Z) zwischen den zwei oder mehreren Koppelelektroden (19, 20) bei mindestens drei unterschiedlichen Frequenzen basiert.

15. Steuereinrichtung nach Anspruch 11, dadurch gekennzeichnet, daß die Koppelelektroden (19, 20) galvanisch mit den Kontaktelementen (22, 23) verbunden sind.

16. Steuereinrichtung nach Anspruch 14, wobei die Windschutzscheibe (18) als Verbundscheibe mit einer äußeren Glasscheibe (25), einer inneren Glasscheibe (25) und einer zwischen der äußeren Glasscheibe (25) und der inneren Glasscheibe (25) vorgesehenen Sicherheitsfolie (27) ausgeführt ist, dadurch gekennzeichnet, daß die Koppelelektroden (19, 20) zwischen der äußeren Glasscheibe (25) und der Sicherheitsfolie (27) vorgesehen sind, zwischen der äußeren Glasscheibe (25) und der Sicherheitsfolie (27) zwei Kontaktelektroden (28, 29) vorgesehen sind, die Koppelelektroden (19, 20) galvanisch mit den Kontaktelektroden (28, 29) verbunden sind und die Kontaktelemente (22, 23), den Kontaktelektroden (28, 29) zugeordnet, auf der der Sicherheitsfolie (27) abgewandten Seite der inneren Glasscheibe (26) vorgesehen sind.

## Claims

1. A method for the contactless measurement of the electrical resistance (R) or of the electrical conductivity of a test material (1), which preferably exists in sheet form, wherein an alternating current is capacitively coupled into the test material (1) with the aid of two coupling electrodes (2, 3), characterised in that the total impedance (Z) is measured at at least three different frequencies, and from this the stray capacitance ($C_S$) between the two coupling electrodes (2, 3), the coupling capacitance ($C_K$) between the two coupling electrodes (2, 3) and the test material (1), and the resistance (R) of the test material (1) are determined.

2. A method according to claim 1, characterised in that the total impedance (Z) is measured using an alternating current of high frequency and from this the stray capacitance ($C_S$) between the two coupling electrodes (2, 3) is determined, that the total impedance (Z) is measured using an alternating current of low frequency and from this the coupling capacitance ($C_K$) between the two coupling electrodes (2, 3) and the test material (1) is determined taking into account the stray capacitance ($C_S$), and that the total impedance (Z) is measured using an alternating current with a frequency lying between the high and the low frequency and from this the resistance (R) of the test material (10) is determined, taking into account the stray capacitance ($C_S$) and the coupling capacitance ($C_K$).

3. A method according to claim 2, characterised in that the real part ($X_R$) of the total impedance (Z) is measured using an alternating current with a frequency at which a phase displacement minimum occurs.

4. A method according to claim 1, wherein the coupling electrodes (2, 3) are disposed fixed, characterised in that the stray capacitance ($C_S$) and/or the coupling capacitance ($C_K$) are only determined once.

5. A method according to any one of claims 1 to 4, characterised in that the capacitive coupling of the alternating current into the test material (1) is effected with the aid of two coupling electrodes of equal area.

6. A method according to any one of claims 1 to 5, characterised in that the capacitive coupling of the alternating current into the test material (1) is effected with the aid of two coupling electrodes (2, 3) constructed as concentric rings.

7. A method according to any one of claims 1 to 6, characterised in that, to reduce the effect of the stray capacitance ($C_S$), part of the current flowing via the stray capacitance ($C_S$) is decoupled via a decoupling electrode (4) situated between the coupling electrodes (2, 3) e.g. situated at earth potential.

8. A method according to any one of claims 1 to 7, characterised in that the measurement is made with two identical electrode arrangements at defined, different distances from the test material (1) in order to increase the accuracy of measurement.

9. A method according to any one of claims 1 to 8, characterised in that the measurement is made with an electrode arrangement with a plurality of concentric rings, and the concentric rings are alternatively connected or are not contacted, as coupling electrodes (2, 3) or as a ring situated at earth potential.

10. A method according to any one of claims 1 to 9, characterised in that the measurement is made with an electrode arrangement in which a - contacting or contactless - temperature measuring instrument is integrated, and the effect of temperature is compensated for with the aid of the measured temperature.

11. A method according to any one of claims 1 to 10, characterised in that the measured values of the stray capacitance ($C_S$) and/or the coupling capacitance ($C_K$) are used for adjusting the distance between the electrode arrangement and the test material (1).

12. The use of the method according to any one of claims 1 to 11 for controlling the windscreen wiper or windscreen wipers of the windscreen (18) of a motor vehicle.

13. A use of the method according to claim 12, characterised in that the total impedance (Z) is measured at five different frequencies, preferably between 200 Hz and 5 MHz.

14. A control device for controlling the windscreen wiper or the windscreen wipers of the windscreen (18) of a motor vehicle, with a sensor (21) consisting of at least two coupling electrodes (19, 20), at least two contact elements (22, 23) connected to the coupling electrodes (19, 20), and an evaluation circuit (24) connected to the contact elements (22, 23), characterised in that the evaluation circuit (24) is based on the detection of the total impedance (Z) between the two or more coupling electrodes (19, 20) at at least three different frequencies.

15. A control device according to claim 14, characterised in that the coupling electrodes (19, 20) are electrically connected to the contact elements (22, 23).

16. A control device according to claim 14, wherein the windscreen (18) is constructed as a composite screen with an outer glass screen (25), an inner glass screen (26) and a safety film (27) provided between the outer glass screen (25) and the inner glass screen (26), characterised in that the coupling electrodes (19, 20) are provided between the outer glass screen (25) and the safety film (27), two contact electrodes (28, 29) are provided between the outer glass screen (25) and the safety film (27), the coupling electrodes (19, 20) are electrically connected to the contact electrodes (28, 29), and the contact elements (22, 23) associated with the contact electrodes (28, 29) are provided on the side of the inner glass screen (26) remote from the safety film (27).

**Revendications**

1. Procédé pour la mesure sans contact de la résistance électrique (R) ou de la conductibilité électrique d'un matériau d'essai (1) qui se présente de préférence sous une forme plane, dans lequel, dans le matériau d'essai (1), on procède à une alimentation capacitive d'un courant alternatif à l'aide de deux électrodes de couplage (2, 3), caractérisé en ce qu'on mesure l'impédance totale (Z) à au moins trois fréquences différentes et, à partir de là, on détermine la capacité parasite ($C_S$) entre les deux électrodes de couplage (2, 3), la capacité de couplage ($C_K$) entre les deux électrodes de couplage (2, 3) et le matériau d'essai (1), ainsi que la résistance (R) du matériau d'essai (1).

2. Procédé selon la revendication 1, caractérisé en ce qu'on mesure l'impédance totale (Z) avec un courant alternatif haute fréquence et on détermine, à partir de là, la capacité parasite ($C_S$) entre les deux électrodes de couplage (2, 3), en ce qu'on mesure l'impédance totale (Z) avec un courant alternatif basse fréquence et, à partir de là, tout en prenant en compte la capacité parasite ($C_S$), on détermine la capacité de couplage ($C_K$) entre les deux électrodes de couplage (2, 3) et le matériau d'essai (1), et en ce qu'on mesure l'impédance totale (Z) à l'aide d'un courant alternatif dont la fréquence se situe entre la haute fréquence et la basse fréquence, et à partir de là, en prenant en compte la capacité parasite ($C_S$) et la capacité de couplage ($C_K$), on détermine la résistance (R) du matériau d'essai (1).

3. Procédé selon la revendication 2, caractérisé en ce qu'on mesure la partie réelle ($X_R$) de l'impédance totale (Z) avec un courant alternatif dont la fréquence présente un minimum de décalage de phase.

**4.** Procédé selon la revendication 1, dans lequel les électrodes de couplage (2, 3) sont disposées de manière stationnaire, caractérisé en ce qu'on ne détermine qu'une seule fois la capacité parasite ($C_S$) et/ou la capacité de couplage ($C_K$).

**5.** Procédé selon l'une quelconque des revendications 1 à 4, caractérisé en ce que l'alimentation capacitive du courant alternatif dans le matériau d'essai (1) a lieu à l'aide de deux électrodes de couplage de même surface.

**6.** Procédé selon l'une quelconque des revendications 1 à 5, caractérisé en ce que l'alimentation capacitive du courant alternatif dans le matériau d'essai (1) a lieu à l'aide de deux électrodes de couplage (2, 3) réalisées sous forme d'anneaux concentriques.

**7.** Procédé selon l'une quelconque des revendications 1 à 6, caractérisé en ce que, pour réduire l'influence de la capacité parasite ($C_S$) à l'intervention d'une électrode de découplage (4) disposée entre les électrodes de couplage (2, 3), par exemple disposée sur le potentiel de base, on découple une partie du courant circulant à l'intervention de la capacité parasite ($C_S$).

**8.** Procédé selon l'une quelconque des revendications 1 à 7, caractérisé en ce que, pour augmenter la précision de mesure, on procède à cette dernière avec deux agencements d'électrodes identiques se trouvant à une distance différente définie par rapport au matériau d'essai (1).

**9.** Procédé selon l'une quelconque des revendications 1 à 8, caractérisé en ce qu'on procède à la mesure avec un agencement d'électrodes comprenant plusieurs anneaux concentriques, et les anneaux concentriques sont sélectivement mis en circuit, soit comme électrodes de couplage (2, 3), soit comme anneaux se situant au potentiel de base, ou bien ne sont pas mis en contact.

**10.** Procédé selon l'une quelconque des revendications 1 à 9, caractérisé en ce qu'on procède à la mesure avec un agencement d'électrodes dans lequel est intégré un appareil de mesure de la température - à contact ou sans contact - et on compense l'influence de la température à l'aide de la température mesurée.

**11.** Procédé selon l'une quelconque des revendications 1 à 10, caractérisé en ce que les valeurs mesurées de la capacité parasite ($C_S$) et/ou de la capacité de couplage ($C_K$) sont utilisées pour régler la distance entre l'agencement d'électrodes et le matériau d'essai (1).

**12.** Application du procédé selon l'une quelconque des revendications 1 à 10, à la commande de l'essuie-glace ou des essuie-glaces du pare-brise (18) d'un véhicule automobile.

**13.** Application du procédé selon la revendication 12, caractérisé en ce que l'impédance totale (Z) est mesurée à cinq fréquences différentes, de préférence entre 200 Hz et 5 MHz.

**14.** Mécanisme pour la commande de l'essuie-glace ou des essuie-glaces du pare-brise (18) d'un véhicule automobile, comprenant un détecteur (21) constitué par au moins deux électrodes de couplage (19, 20), au moins deux éléments de contact (22, 23) reliés aux électrodes de couplage (19, 20) et un circuit de détection décision raccordé à un des éléments de contact (22, 23), caractérisé en ce que le circuit de détection décision (24) se base sur une détection de l'impédance totale (Z) entre les deux électrodes de couplage ou plus (19, 20) à au moins trois fréquences différentes.

**15.** Mécanisme de commande selon la revendication 11, caractérisé en ce que les électrodes de couplage (19, 20) sont reliées par galvanisation aux éléments de contact (22, 23).

**16.** Mécanisme de commande selon la revendication 14, dans lequel le pare-brise (18) est réalisé en un pare-brise composite comprenant une vitre externe (25), une vitre interne (26) et une feuille de protection (27) prévue entre la vitre externe (25) et la vitre interne (26), caractérisé en ce que les électrodes de couplage (19, 20) sont prévues entre la vitre externe (25) et la feuille de protection (27), deux électrodes de contact (28, 29) sont prévues entre la vitre externe (25) et la feuille de protection (27), les électrodes de couplage (19, 20) sont reliées aux électrodes de contact (28, 29) par galvanisation, et les éléments de contact (22, 23) attribués aux électrodes de contact (28, 29) sont prévus sur le côté de la vitre interne (26), qui se détourne de la feuille de protection (27).

# Fig.1

# Fig. 2

Fig. 3

Fig.4

Fig. 5

Gesamtimpedanz in Ohm

Phasenverschiebung in Grad

Frequenz in Kilohertz

EP 0 451 701 B1

**Fig.6**

Phasenverschiebung in Grad

Gesamtimpedanz in Ohm

Betrag

Realteil

Imaginärteil

Frequenz in Kilohertz

Meßfehler in Prozent

Frequenz in Kilohertz

Fig. 7

Fig. 8

Fig. 9

27

25

28, 29

22, 23

19, 20

26

Fig. 10

$C_{K,3}$

$C_S$

$C_{K,1}$

R

24

$C_{K,2}$

$C_{K,4}$

Fig. 11